# EUROPEAN PATENT SPECIFICATION

(11) **EP 2 921 871 B1**
(45) Date of publication and mention of the grant of the patent: **05.02.2020**
(21) Application number: 14160881.0
(22) Date of filing: 20.03.2014
(51) Int. Cl.: G01R 31/42, H02M 7/483

(54) **Connection integrity testing method and apparatus for multi-stage voltage source converters**
Überprüfungsverfahren und -vorrichtung zur Feststellung von funktionstüchtigen Verbindungen in modularen mehrstufigen spannungsgespeisten Umrichtern
Procédé et dispositif de test d'intégrité de connexion pour convertisseurs de source de tension à plusieurs étages

(43) Date of publication of application: 23.09.2015
(73) Proprietor: General Electric Technology GmbH, 5400 Baden (CH)
(72) Inventor: Couch, Philip, Dvon EX14 9HG (GB)
(74) Representative: Openshaw & Co.

(56) References cited:
- DE-A1-102011 117 683
- US-A1- 2011 235 221

## Description

This application relates to methods and apparatus for testing the integrity of connections of elements of a voltage source converter and in particular to methods and apparatus for testing the integrity of electrical connections of series connected modules following installation or maintenance of a voltage source converter.

HVDC (high-voltage direct current) electrical power transmission uses direct current for the transmission of electrical power. This is an alternative to alternating current electrical power transmission which is more common. There are a number of benefits to using HVDC electrical power transmission. In order to use HVDC electrical power transmission, it is typically necessary to convert alternating current (AC) to direct current (DC) and back again. Historically this has been done by using thyristor converters which are sometimes known as line-commutated converters (LCC).

Recent developments in the power electronics field have led to an increased use of voltages-source converters (VSC) for AC-DC and DC-AC conversion. VSCs typically comprise six converter arms (for a three phase AC input/output), each of which connects one DC terminal to one AC terminal. Each arm comprises an apparatus which is termed a valve and which typically comprises a plurality of series connected elements.

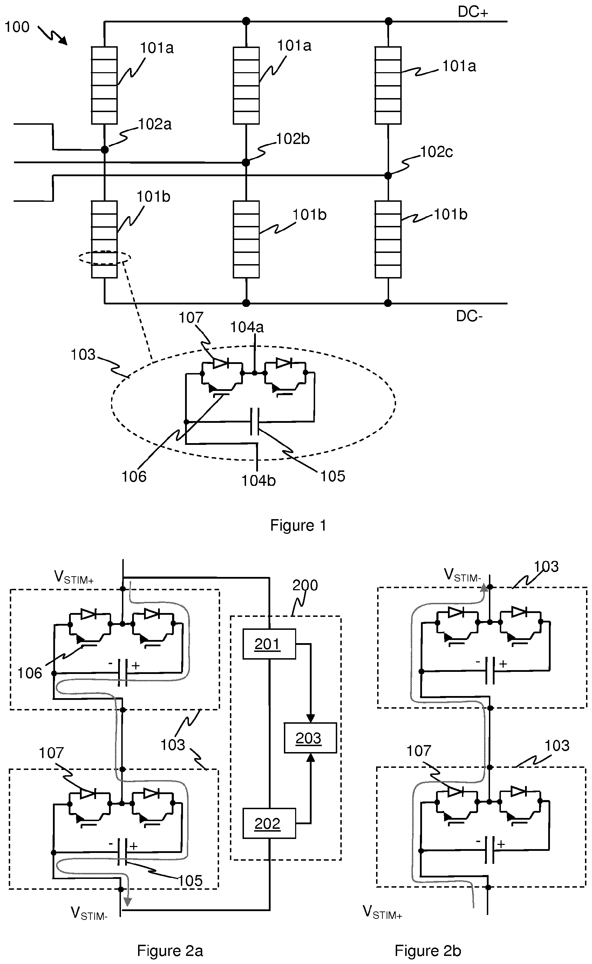

In one known type of VSC, referred to as a modular multilevel converter (MMC), each valve comprises a series of cells connected in series, each cell comprising an energy storage element, such as a capacitor, and a switch arrangement that can be controlled so as to either connect the energy storage element in series between the terminals of the cell or bypass the energy storage element. Figure 1 illustrates the basic principles of an MMC type converter 100. The converter 100 illustrated in figure 1 is arranged with three phase limbs, each phase limb having a first valve 101a connecting the high side DC terminal DC₊ to the relevant AC node (102a-c) and a second valve 101b connecting the relevant AC node to the low side DC terminal DC-.

Each valve comprises a plurality of series connected cells 103, which are often referred to as sub-modules (with a plurality of cells together forming a valve module). The sub-modules 103 of a valve have two terminals, 104a and 104b, for series connection and each comprise at least one energy storage element such as a capacitor 105 and a switch arrangement for connecting the energy storage element in series between the terminals or bypassing it. The switch arrangement typically comprises a plurality of switches 106, such as insulated gate bipolar transistors (IGBTs), each having an associated freewheel diode 107. Figure 1 illustrates a half-bridge arrangement of switches 106 although in some converters a full-bridge arrangement where the terminals of the capacitor 105 can each be selectively connected to either of the terminals of the sub-module may be used.

In use the energy storage elements of the sub-modules of the valve are selectively connected or bypassed at different times so as to vary over the time the voltage difference across the valve. By using a relatively large number of sub-modules and timing the switching appropriately the valve can synthesise a stepped waveform that, for example, approximates to a sine wave and which contains low levels of harmonic distortion.

In a practical MMC type VSC there may be a relatively large number of individual sub-modules. For instance, for one proposed MMC, each valve may comprise around 350 sub-modules connected in series. Following installation or maintenance of a VSC there is a need to check that the valve has been installed correctly and/or is operating as expected. Typically this is done by a process of visual inspection and/or testing of each sub-module individually which is laborious and time consuming.

Some other designs of VSC also use chain-link circuits comprising a number of series connected sub-modules, each sub-module having an energy storage element and switch arrangement such as described with reference to figure 1. Similar issues also arise with regard to checking the installation of the chain-link circuits of such VSC designs.

US 2011/0235221 A1 discloses a VSC comprising series connected cells. DE 10 2011 117 683 A1 specifies a testing procedure for an inverter.

The invention provides a method of testing a first plurality of series connected cells of a voltage source converter according to claim 1 and an apparatus for testing a plurality of series connected cells of a voltage source converter according to claim 12. Preferred embodiments are defined in the dependent claims.

Embodiments of the present invention therefore provide methods and apparatus that at least ease the checking or testing of a plurality of series connected components of a VSC.

Thus according to the present invention there is provided a method of testing a first plurality of series connected cells of a voltage source converter, wherein each cell comprises an energy storage element and a plurality of switch elements and wherein each switch element has an associated freewheeling diode, the method comprising:
applying an electrical test stimulus to the first plurality of series connected cells, wherein the electrical test stimulus has a voltage that is lower than the rated operating voltage of the voltage source converter but which is greater than a threshold voltage which is sufficient to forward bias freewheeling diodes of each of the first plurality of series connected to provide a conduction path through the plurality of series connected cells; and
monitoring the electrical characteristics of said first plurality of series connected cells to said electrical test stimulus.

The electrical test stimulus may have a voltage which is lower than the rated operating voltage of each of the individual cells of said first plurality of series connected cells.

In some embodiments the electrical test stimulus has a voltage that varies over time, for example the electrical test stimulus may have a voltage that increases from a level below the threshold voltage to a value which is greater than the voltage threshold.

The electrical test stimulus may be current limited.

Monitoring the electrical characteristics may comprise monitoring the electrical current characteristics of any current flowing through the first plurality of series connected cells. The method may further comprise comparing the monitored electrical characteristics with expected characteristics.

The cells may comprise half-bridge sub-modules where the plurality of switch elements are configured such that the energy storage element can, in use, by selectively connected in series between the terminals of the cell or bypassed. In which case the electrical stimulus may be applied in a forward direction, such that the conduction path through the plurality of series connected cells comprises the energy storage elements, and/or in a reverse direction, such that the conduction path through the plurality of series connected sub-modules comprises the bypass path.

In some embodiments applying the electrical test stimulus may comprise applying a first stimulus of a first polarity followed by applying a second stimulus of the opposite polarity.

In some embodiments the electrical test stimulus may, for at least part of the time, have a voltage in the range of 400V to 600V.

The method may comprise connecting portable test equipment to the first plurality of series connected cells to provide said test stimulus and monitor said electrical characteristics.

The first plurality of series connected cells may comprise a valve of the voltage source converter.

The invention also relates to testing apparatus. Thus in another aspect of the invention there is provided an apparatus for testing a plurality of series connected cells of a voltage source converter, wherein each cell comprises an energy storage element and a plurality of switch elements and wherein each switch element has an associated freewheeling diode, the apparatus comprising:
a voltage generator for applying an electrical test stimulus to the first plurality of series connected cells, wherein the electrical test stimulus has a voltage that is lower than the rated operating voltage of the voltage source converter but which is greater than a threshold voltage which is sufficient to forward bias freewheeling diodes of each of the first plurality of series connected to provide a conduction path through the plurality of series connected cells; and
a monitor for monitoring the electrical characteristics of said first plurality of series connected cells to said electrical test stimulus.

The voltage generator may be configured to generate the electrical test stimulus with a voltage which is lower than the rated operating voltage of each of the individual cells of said first plurality of series connected cells. The voltage generator may be configured to generate the electrical test stimulus with a voltage that varies over time, for instance to generate an electrical test stimulus with a voltage that increases from a level below the threshold voltage to a value which is greater than the voltage threshold. The voltage generator may comprise a current limited voltage source.

The monitor may comprise a current monitor for monitoring the electrical current characteristics of any current flowing through the first plurality of series connected modules.

The data provided by the current monitor may be output for analysis or in some embodiments the apparatus may further comprise a data processor for comparing the monitored electrical characteristics with expected characteristics.

In some embodiments the voltage generator may be configured to apply a first stimulus of a first polarity followed by applying a second stimulus of the opposite polarity.

The voltage generator may be configured to generate, for at least part of the time, the electrical test stimulus having a voltage in the range of 400V to 600V.

Conveniently the apparatus is portable.

The invention will now be described by way of example only with respect to the following drawings, of which:
Figure 1 illustrates an example of a known modular multilevel converter;
Figures 2a and 2b illustrate how a test stimulus may be applied to a plurality of series connected cells of a VSC;
Figure 3 illustrates the principles of a time varying test stimulus and monitored current characteristic; and
Figure 4 shows a flowchart illustrating one example of a method according to an embodiment of the present invention.

Embodiments of the present invention relate to apparatus and method for testing the connection integrity of a first plurality of series connected cells of a voltage source converter (VSC) where each cell comprises an energy storage element and a plurality of switch elements and wherein each switch element has an associated parallel freewheeling diode. The first plurality of cells may for instance form at least part of a valve of a modular multilevel converter (MMC) type VSC. The cells may comprise half-bridge sub-modules where the plurality of switch elements are configured such that the energy storage element can, in use, be selectively connected in series between the terminals of the cell or bypassed.

As described above in relation to Figure 1 in a known MMC type converter a valve 101a, 101b of the VSC may comprise a large number of series connected cells 103, commonly referred to as sub-modules. For some embodiments of MMC converters there may for example be around 350 sub-modules in each valve.

Following installation or maintenance of a VSC there is a desire to check that the components of the valve are installed and operating correctly. Each sub-module will typically comprise associated control electronics that may include or implement various self-test equipment/processes to monitor the operation of the valve sub-module in use.

Such self test equipment in general however is only effective when the sub-module is powered and operating within the normal voltage operating regime of the VSC, which in HVDC applications involves very high voltages of the order of hundreds of kilovolts. In use these high voltages are shared across the multiple cells of the valve and thus no one cell or sub-module experiences such a high voltage. Were there an error in connectivity however and the valve were energised to the normal operating voltages the high voltages could be applied to just a small number of elements which could result in catastrophic failure and damage.

It is therefore conventional practice to perform a visual inspection of the connections of the various sub-modules and then perform a test of each individual sub-module in turn before energising the valve. This represents a time consuming and laborious process which can significantly add to the time and expense of commissioning a VSC or performing maintenance.

Embodiments of the present invention therefore perform an electrical test of the connection integrity of the first plurality of cells, e.g. sub-modules, that is safe and relatively simple and quick to perform. The general method of the present invention involves applying an electrical test stimulus to the first plurality of series connected cells, which may for instance comprise an entire valve of a VSC. The test stimulus has a voltage that is much lower than the rated operating voltage of the valve, i.e. the voltage level that the series connected cells are capable of withstanding. In some embodiments the voltage of the test stimulus is lower than the rated operating voltage of a single cell or sub-module, i.e. the voltage which an individual sub-module can safely handle. The voltage of the test stimulus may vary over time and may for instance increase over time. For at least part of the time the test stimulus may have a voltage which has a value which is greater than a threshold value sufficient to forward bias freewheeling diodes of each of the first plurality of sub-modules to provide a conduction path through the plurality of series connected sub-modules. Preferably the test stimulus is current limited so as to restrict the amount of current that may flow in a fault situation. The method may comprise monitoring the electrical characteristics of the first plurality of series connected sub-modules in response to the test stimulus to determine whether the sub-modules and their capacitors are connected correctly. This may involve monitoring the current and/or voltage characteristics of the first plurality of the series connected cells and comparing such monitored characteristics with an expected or reference voltage/current characteristic.

Embodiments of the present invention therefore apply a relatively low voltage stimulus to the first plurality of series connected cells to be tested. This could be the whole valve of an MMC, although in some instances it may be wished to test just part of a valve. This test stimulus may be applied without the sub-modules being fully powered and thus the switches 106 are not operational. The freewheel diodes will however respond to the application of the test stimulus and once the forward bias is sufficient the diodes will conduct and a current will flow. Depending on the polarity of the test stimulus applied a current may be caused to flow via the energy storage elements of the sub-modules or via the bypass path as illustrated in figures 2a and 2b.

Figures 2a and 2b illustrate a test stimulus being applied to a plurality of series connected cells 103. In these examples each cell 103 is a sub-module as described above in relation to figure 1. Figures 2a and 2b each illustrate just two series connected modules for clarity but as mentioned the method of the present invention may be used to test an entire valve of a VSC which may comprise of the order of 350 sub-modules or more.

As mentioned above the sub-modules 103 illustrated are based on a half-bridge switch arrangement. Figures 2a and 2b illustrate a conventional MMC arrangement in which each of the sub-modules of a valve are connected in the same way as one another with terminal 104a being a high side terminal and terminal 104b being a low side terminal. In use the high side terminal of one sub-module may be connected to the low side terminal of the next sub-module. The high side terminal of the series connection is connected to the high side DC voltage, DC₊, for an upper valve 101 a and to the AC node 102a-c for a lower valve, with the low side terminal being connected to the AC node or the low side DC terminal DC- respectively.

Figure 2a illustrates that by applying a test stimulus which has the same polarity as the expected voltage difference across the series connection in use the test stimulus can test the connection of the cells via the path including the energy storage element. In other words a test stimulus voltage V_{STIM+} is applied to the high side terminal of the top sub-module that is more positive than a stimulus voltage V_{STIM-} applied to the low side terminal of the bottom sub-module. In some embodiments the stimulus voltage V_{STIM-}may be a fixed voltage, such as ground or some other low reference potential.

As shown in figure 2a if the voltage across the series connected cells 103 is sufficiently high the freewheel diode 107 associated with the switch 106 in the path including the energy storage element 105 will be forward biased in each of the sub-modules and a current can flow. This current will cause some charging of the energy storage elements 105 of the sub-modules.

As mentioned above a valve may have of the order of 350 or so series connected sub-modules. Each sub-module may be rated to operate in use with an operation voltage for that sub-module. In some embodiments the rated operation voltage for the sub-modules may be of the order of 2kV, i.e. the sub-module is designed to withstand a voltage difference of 2kV across the sub-module. The voltage needed to forward bias the freewheel diode associated with an individual power switch is typically of the order of about 1V or so. Thus if a voltage is applied across the whole valve which is greater than 350V then such a voltage should be sufficient to forward bias all the freewheel diodes in a conduction path through the valve. If such an applied voltage is no greater than the operation voltage for a given sub-module then the stimulus voltage will be safe, even if it is applied across just a single sub-module, e.g. due to a misconnection of the sub-modules or other fault condition. If the sub-modules are all connected correctly such an applied stimulus voltage should be sufficient to forward bias the freewheel diode in each of the series connected sub-modules and thus permit a current to flow through the whole valve, as indicated by the grey arrow in figure 2a. Detecting this current flow can be used as an indication that the sub-modules are all electrically connected and the capacitors of the sub-modules are connected correctly and thus indicates that if - a high voltage is applied it will be shared across all of the sub-modules of the valve. Applying a test stimulus which has the same polarity as the expected voltage difference across the series connection in use therefore allows examination of the capacitance charging characteristics. This may check that the sub-modules are correctly connected to one another and that the capacitors are correctly connected into a series chain, with broadly the expected series capacitance value.

In some embodiments therefore applying a test stimulus may comprise applying a voltage which is above a threshold voltage that is sufficient to forward bias all the freewheel diodes of the sub-modules in a conduction path through the series connected sub-modules and determining whether a current flows through the series connected sub-modules. As previously described the voltage applied may be low enough to be within the normal voltage operating range of an individual sub-module and thus is safe to apply even if the sub-modules have not been correctly connected. For instance for a valve comprising 350 sub-modules applying the test stimulus could comprise applying a voltage of about 400V to 600V at the top (high side) of the valve and connecting the bottom (low side) of the valve to ground and monitoring for a current flowing at the low side.

In the event that the threshold voltage required to forward bias the freewheel diodes of an entire valve would require a voltage magnitude greater than the normal rated operating voltage of an individual sub-module the valve could be tested by testing the connections of portions of the valve in turn, each portion being chosen so that the relevant threshold voltage for that portion is lower than the operating voltage limits for each sub-module. For instance the connection integrity of a top portion of the valve could be tested by applying a stimulus V_{STIM+} to the top of the valve with a first point within the series connection being connected to ground. A bottom portion of the valve could then be tested by connecting the bottom of the valve to ground and applying the stimulus V_{STIM+} to a second point within the series connection. The first point and the second point could be at the same point in the series connection to divide the valve into at least two sections or there may be some overlap between the two portions tested to ensure that the connection between the two portions is also good.

The stimulus applied could be a fixed voltage but there may be advantages in providing a stimulus which has a voltage which varies over time. For instance the voltage could be increased over time from below a level which is below the expected threshold voltage, i.e. sufficient to forward bias all the freewheel diodes in the expected conduction path, to a voltage level which is above the expected threshold level. It would be expected that there would be substantially no current flow below the threshold voltage and that the current flow may increase with increasing voltage above the threshold voltage. If there is significant current flow at a voltage much lower than the threshold voltage this could indicate a short circuit between different parts of the series connection or to ground. If no current flows even at a voltage comfortably above the threshold voltage this could indicate a break in the series connection or, if the current is measured at the lower point of the series connection, a short circuit to ground somewhere upstream in series connection.

In addition the evolution of the current flow over time with a fixed or increasing voltage above the threshold voltage may also be monitored as part of the testing. For instance the current flow may depend on the charging of the energy storage elements, e.g. capacitors, and thus the current flow may be compared with an expected characteristic in order to check that the capacitors are connected and operating as expected, for instance that the series capacitance of the capacitor chain is as expected. The resistance properties of the diodes may also vary with varying voltage above the threshold voltage.

The expected current-voltage characteristics for the plurality of series connected cells under test to a particular stimulus may therefore be determined based on the number and type of sub-modules, for instance determined from a suitable model or based on previous measurements. The actual current voltage characteristics under test can be measured and compared to the expected characteristics to determine whether the plurality of series connected modules are operating as expecting, thus indicating any problems in connection.

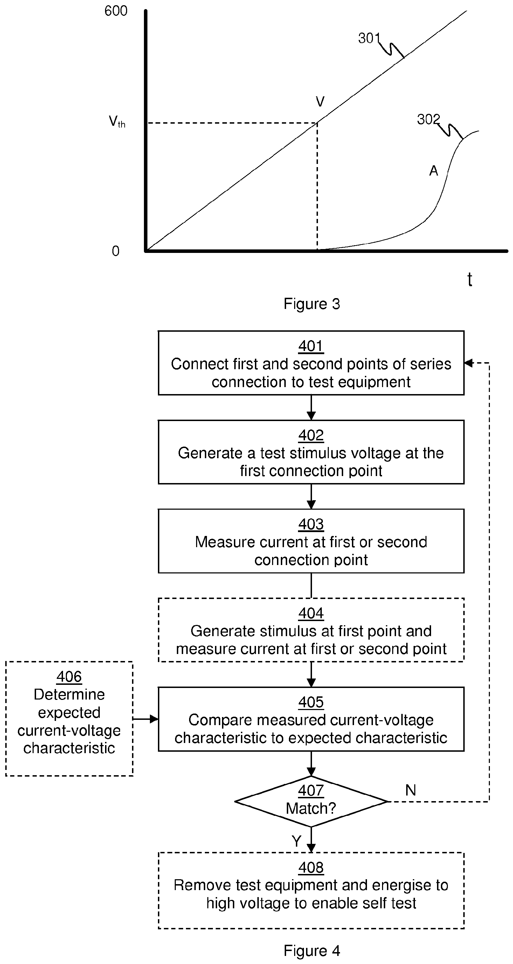

Figure 3 illustrates the principles of how such a test stimulus may be applied and used to provide useful test information. Figure 3 illustrates a voltage stimulus 301 that may be applied to the plurality of series connected modules, e.g. by holding the low side at ground and applying a time varying stimulus voltage V_{STIM+} to the high side. In this example a steady voltage ramp is applied from zero up to a value of about 600V, which is above the expected voltage threshold Vth for forward biasing all the freewheel diodes of the sub-modules but is within the safe operating voltage limit of an individual sub-module. Curve 302 illustrates one example of a possible resultant current characteristic. It can be seen than no current is expected until the applied voltage exceeds the threshold voltage. Once the threshold voltage is exceeded a current will be expected to start flowing. The current may increase over time with increasing voltage as the diodes become more forward biased and as the capacitors start charging. The exact current characteristics will depend on the particular types and connection of sub-modules and as mentioned can be modelled or based on previous measurements.

In the event that the measured characteristics do not match the expected characteristics this can be indicative of a problem in connection of the sub-modules. Further testing or inspection may then be performed to identify the problem. The testing performed may depend on the actual measured characteristics.

For instance if no current is measured at all this may indicate a break in connection somewhere in the conduction path. To help narrow down the location of the problem connection(s) the method of testing may be repeated but on portions of the valve at a time. For example if there is no current when testing the whole valve separate tests may be performed on the top half and then the bottom half of the valve. If there is current flow in the top half of the valve but no current flow in the bottom half of the valve this indicates that the top half may be connected correctly and the problem is in the lower half. Such testing may be repeated on progressively smaller sections of the valve to help narrow down the location of the fault.

Were instead current to flow but starting at a lower than expected voltage threshold and having different than expected characteristics this could indicate that sections of the valve have not been connected correctly or are short-circuited. Again progressive testing on portions of the valve can help in localising the problem(s).

If however the measured current characteristic does match the expected current characteristic then this is evidence that the sub-modules have all been connected correctly. The valve can therefore be energised to a higher voltage state with confidence that the higher voltage will be correctly shared by the series connected sub-modules. In the higher energised state the built in self test circuitry/routines can be operated to perform further testing of the valve before full operation.

As mentioned previously the series connected cells, e.g. valve sub-modules, typically will have some self-test functionality that can be operated when the cell is powered up, i.e. energised to a high voltage state. It has been appreciated that the series connection, e.g. valve, can be energised to a level to permit the self-test to function without fully starting the converter. The capacitors of the cells, e.g. sub-modules, will share such an initial charge, distributing the bias voltage equally between the various sub-modules and making it safe to power the valve for a short time, before the sharing becomes unbalanced. This should however be long enough to allow the self-testing to function. This sharing of the initial charge/voltage is only ensured however if the capacitors of the various cells are all connected correctly. An open circuit capacitor for example will result in an unacceptable voltage drop in a sub-modules which could cause consequent damage.

The method of embodiments of the present invention thus provides a quick and simple way of checking the connection integrity of a plurality of series connected cells of a VSC using a safe voltage level so as to confirm that a high voltage can be applied, which can then allow the built in self test circuitry to operate to perform further testing.

The use of relatively low voltages also has other advantages. First the equipment required to generate the test stimulus may be portable. A voltage generator for generating a voltage of the order of a few hundred volts can be relatively compact and portable and thus can be moved round a valve hall of an HVDC power station with relative ease to apply the voltage stimulus where required. One particular aspect of the present invention is a portable voltage generator for generating a voltage test stimulus as described above.

Figure 2a illustrates that a portable voltage generator 201 may be removably connected to an appropriate part of the series connected cells in order to perform the test. This voltage generator 201 may be a current limited portable voltage source. The voltage generator 201 may be connected to first and second connection points of the series connected cells to generate a desired voltage difference between the first and second connection points. In some embodiments however one of the first or second connection points may be provided by a separate connection to ground or some other reference voltage. To monitor the electrical characteristics a current monitor 202 may be arranged to monitor the current at point of the appropriate part of the series connected cells, but conveniently the current may be monitored at the first and/or second connection points. The voltage generator 201 and current monitor 202 may form part of the test apparatus 200, which may also have a data processor 203 for receiving the current-voltage characteristics and determining whether there is a fault in connection of the series connected cells.

In addition using voltages of a few hundred volts does not require the same degree of safety precautions as several hundred kilovolts. Thus it may not be necessary to evacuate the valve hall when performing the testing of embodiments of the present invention as would likely be necessary if kV levels where to be used.

The discussion above has focussed on applying a test stimulus in the forward direction with respect to the valve connections. Additionally or alternatively a test stimulus may be applied with a reverse bias with respect to the normal operating conditions of the valve. As illustrated in figure 2b a reverse bias may be created by ensuring that a test stimulus voltage V_{STIM+} applied to the low side terminal of the bottom sub-module is more positive than a stimulus voltage V_{STIM-} applied to high side terminal of the top sub-module. In this case provided that the voltage difference applied is sufficient a current will flow via the bypass path of each sub-module as illustrated in figure 2b.

In this arrangement the connectivity of the sub-modules may be checked but the connectivity of the capacitors will not be checked (for a conventional half-bridge arrangement). It may nevertheless be beneficial to apply a test stimulus in both the forward and reverse directions before energising the valve to fully test all the connections.

It will also be appreciated that other types of converter design may use different types or connections of sub-modules. For instance in an MMC with sub-modules based on a full-bridge switch arrangement then the conductions paths via the freewheel diodes may include the capacitor for both a forward direction test stimulus and a reverse direction stimulus. Some converter designs may also include a plurality of half-bridge sub-modules arranged for one polarity with at least some half-bridge sub-modules arranged for the opposite polarity. In this case applying a stimulus in the forward direction may activate the path including the capacitor in some sub-modules but the bypass path in others where applying a stimulus in the reverse direction has the opposite effect. In any case however the expected current-voltage response can be determined and compared to the monitored response.

Figure 4 illustrates in general terms a flow-chart according to a method of the present invention.

In step 401 test equipment is electrically connected to first and second points of the series connected elements to be tested. The first and second points define the section of the series connection to be tested and thus defines the first plurality of cells of the VSC under test. Where the series connection to be tested comprises at least part of a valve of the VSC the whole series connection forming the valve may be tested initially. In some embodiments the first point may be connected to first test equipment and the second point may be connected to second test equipment. At least one of the first test equipment and second test equipment may comprise a voltage generator, e.g. 201 and at least one of the first test equipment and second test equipment may comprise a current meter, e.g. 202. In some embodiments the first test equipment may be the same apparatus as the second test equipment, i.e. a single apparatus 200 has connections for both points. In some embodiments if the series connected cells are operably connected to ground such a ground connection may be used as the second connection point and it may be possible to connect test equipment to the first connection point only.

In step 402 a test stimulus voltage is generated at the first connection point. As mentioned this test voltage stimulus may have a time varying voltage and has a maximum voltage that does not exceed the normal operating voltage limit of an individual cell of the VSC. This may be performed without the cells of the VSC being otherwise powered. Any resulting current flowing between the first and second connection points is monitored (403). Conveniently the current is monitored at the first or the second connection point. In some embodiments a stimulus may also be applied in the reverse direction (404).

The current-voltage characteristics may then be compared, 405, to an expected characteristic. The expected characteristic may be predetermined, e.g. based on the number and type of sub-modules forming the valve. In some embodiments however the expected characteristics may be determined (406) once the first and second connection points have been established. The characteristics may comprise an expected voltage threshold for any current flow and/or current rise times. This may be performed in a data processor 203 of the test equipment or the measured characteristics may be stored or output for later analysis.

In the event that the monitored current-voltage characteristics match the expected characteristics the relevant section of the series connection may be determined to be connected correctly, at least to proceed to a next stage of testing. The test equipment may be removed (408) and, if the whole valve has been tested and passed, the valve may subsequently be energised to a higher voltage level to enable self testing.

In the event that the current voltage characteristics do not match, this can be used an indication of a problem. In some embodiments to help determine the location of the problem connection the method may be repeated but for only part of the series connection.

In general therefore the methods and apparatus of the present invention provide a simple, quick and safe way of testing the connection integrity of a plurality of series connected cells of a VSC that can be implemented using simple and portable test equipment and that provide assurance that the series connected cells can be energised to a high voltage level, thus enabling various self test processes and routines to operate.

## Claims

1. A method of testing a first plurality of series connected cells (103) of a voltage source converter (100), wherein each cell (103) comprises an energy storage element (105) and a plurality of switch elements (106), wherein each switch element has an associated freewheeling diode (107), and wherein the cells comprise half-bridge sub-modules where the plurality of switch elements are configured such that the energy storage element can, in use, be selectively connected in series between the terminals of the cell or bypassed, the method comprising:
applying an electrical test stimulus (V_{STIM}; 301) to the first plurality of series connected cells, wherein the electrical test stimulus has a voltage that is lower than the rated operating voltage of the voltage source converter but which is greater than a threshold voltage (Vₜₕ) which is sufficient to forward bias freewheeling diodes of each of the first plurality of series connected cells to provide a conduction path through the first plurality of series connected cells; and
monitoring the electrical characteristics of said first plurality of series connected cells to said electrical test stimulus; wherein
the electrical stimulus (V_{STIM}) is applied in a forward direction such that the conduction path through the plurality of series connected cells comprises the energy storage elements; and
the electrical stimulus (V_{STIM}) is applied in a reverse direction such that the conduction path through the plurality of series connected cells comprises the bypass path.

2. A method as claimed in claim 1 wherein the electrical test stimulus has a voltage which is lower than the rated operating voltage of each of the individual cells of said first plurality of series connected cells.

3. A method as claimed in claim 1 or claim 2 wherein the electrical test stimulus has a voltage (301) that varies over time.

4. A method as claimed in claim 3 wherein the electrical test stimulus has a voltage (301) that increases from a level below the threshold voltage to a value which is greater than the threshold voltage.

5. A method as claimed in any preceding claim wherein the electrical test stimulus is current limited.

6. A method as claimed in any preceding claim wherein monitoring the electrical characteristics comprises monitoring the electrical current characteristics of any current flowing through the first plurality of series connected cells.

7. A method as claimed in any preceding claim comprising comparing the monitored electrical characteristics with expected characteristics.

8. A method as claimed in any preceding claim wherein applying the electrical test stimulus comprising applying a first stimulus of a first polarity followed by applying a second stimulus of the opposite polarity.

9. A method as claimed in any preceding claim wherein, for at least part of the time, the electrical test stimulus has a voltage in the range of 400V to 600V.

10. A method as claimed in any preceding claim comprising connecting portable test equipment (200) to the first plurality of series connected cells to provide said test stimulus and monitor said electrical characteristics.

11. A method as claimed in any preceding claim wherein said first plurality of series connected cells comprise a valve (101) of the voltage source converter.

12. An apparatus (200) for testing a plurality of series connected cells (103) of a voltage source converter (100), wherein each cell comprises an energy storage element (105) and a plurality of switch elements (106), wherein each switch element has an associated freewheeling diode (107), and wherein the cells comprise half-bridge sub-modules where the plurality of switch elements are configured such that the energy storage element can, in use, be selectively connected in series between the terminals of the cell or bypassed, the apparatus comprising:
a voltage generator (201) for applying an electrical test stimulus (V_{STIM}; 301) to the first plurality of series connected cells, wherein the electrical test stimulus has a voltage that is lower than the rated operating voltage of the voltage source converter but which is greater than a threshold voltage (Vₜₕ) which is sufficient to forward bias freewheeling diodes of each of the first plurality of series connected cells to provide a conduction path through the first plurality of series connected cells; and
a monitor (202) for monitoring the electrical characteristics of said first plurality of series connected cells to said electrical test stimulus; wherein
the electrical stimulus (V_{STIM}) is applied in a forward direction such that the conduction path through the plurality of series connected cells comprises the energy storage elements; and
the electrical stimulus (V_{STIM}) is applied in a reverse direction such that the conduction path through the plurality of series connected cells comprises the bypass path.

## Patentansprüche

1. Verfahren zur Überprüfung einer ersten Vielzahl von in Reihe verbundenen Zellen (103) eines Spannungsquellenwandlers (100), wobei jede Zelle (103) ein Energiespeicherelement (105) und eine Vielzahl von Schaltelementen (106) umfasst, wobei jedes Schaltelement eine verknüpfte Freilaufdiode (107) aufweist, und wobei die Zellen Halbbrückensubmodule umfassen, wo die Vielzahl von Schaltelementen so konfiguriert ist, dass das Energiespeicherelement in Verwendung selektiv in Reihe zwischen den Anschlüssen der Zelle verbunden oder überbrückt sein kann, das Verfahren umfassend:
Anlegen eines elektrischen Prüfstimulus (V_{STIM}; 301) an die erste Vielzahl von in Reihe verbundenen Zellen, wobei der elektrische Prüfstimulus eine Spannung aufweist, die niedriger als die Nennbetriebsspannung des Spannungsquellwandlers aber größer als eine Schwellenspannung (Vₜₕ) ist, die ausreicht, um Freilaufdioden jeder der ersten Vielzahl von in Reihe verbundenen Zellen in Vorwärtsrichtung vorzuspannen, um einen Leitungsweg durch die erste Vielzahl von in Reihe verbundenen Zellen bereitzustellen; und
Überwachen der elektrischen Eigenschaften der ersten Vielzahl von in Reihe verbundenen Zellen zum elektrischen Prüfstimulus; wobei
der elektrische Stimulus (V_{STIM}) in einer Vorwärtsrichtung angelegt wird, sodass der Leitungsweg durch die Vielzahl von in Reihe verbundenen Zellen die Energiespeicherelemente umfasst; und
der elektrische Stimulus (V_{STIM}) in einer umgekehrten Richtung angelegt wird, sodass der Leitungsweg durch die Vielzahl von in Reihe verbundenen Zellen den Überbrückungsweg umfasst.

2. Verfahren nach Anspruch 1, wobei der elektrische Prüfstimulus eine Spannung aufweist, die niedriger als die Nennbetriebsspannung von jeder der individuellen Zellen der ersten Vielzahl von in Reihe verbundenen Zellen ist.

3. Verfahren nach Anspruch 1 oder Anspruch 2, wobei der elektrische Prüfstimulus eine Spannung (301) aufweist, die im Laufe der Zeit variiert.

4. Verfahren nach Anspruch 3, wobei der elektrische Prüfstimulus eine Spannung (301) aufweist, die sich von einem Grad unter der Schwellspannung auf einen Wert, der größer als die Schwellspannung ist, erhöht.

5. Verfahren nach einem der vorstehenden Ansprüche, wobei der elektrische Prüfstimulus strombegrenzt ist.

6. Verfahren nach einem der vorstehenden Ansprüche, wobei Überwachen der elektrischen Eigenschaften Überwachen der elektrischen Stromeigenschaften von jedem Strom ist, der durch die erste Vielzahl von in Reihe verbundenen Zellen fließt.

7. Verfahren nach einem der vorstehenden Ansprüche, umfassend Vergleichen der überwachten elektrischen Eigenschaften mit erwarteten Eigenschaften.

8. Verfahren nach einem der vorstehenden Ansprüche, wobei Anlegen des elektrischen Prüfstimulus Anlegen eines ersten Stimulus einer ersten Polarität, gefolgt von Anlegen eines zweiten Stimulus der entgegengesetzten Polarität umfasst.

9. Verfahren nach einem der vorstehenden Ansprüche, wobei für mindestens einen Teil der Zeit der elektrische Prüfstimulus eine Spannung in der Reichweite von 400V bis 600V aufweist.

10. Verfahren nach einem der vorstehenden Ansprüche, umfassend Verbinden tragbarer Prüfausrüstung (200) mit der ersten Vielzahl von in Reihe verbundenen Zellen, um den Prüfstimulus bereitzustellen und die elektrischen Eigenschaften zu überwachen.

11. Verfahren nach einem der vorstehenden Ansprüche, wobei die erste Vielzahl von in Reihe verbundenen Zellen ein Ventil (101) des Spannungsquellwandlers umfasst.

12. Einrichtung (200) zum Prüfen einer Vielzahl von in Reihe verbundenen Zellen (103) eines Spannungsquellwandlers (100), wobei jede Zelle ein Energiespeicherelement (105) und eine Vielzahl von Schaltelementen (106) umfasst, wobei jedes Schaltelement eine verknüpfte Freilaufdiode (107) aufweist und wobei die Zellen Halbbrückensubmodule umfassen, wo die Vielzahl von Schaltelementen so konfiguriert ist, dass das Energiespeicherelement in Verwendung selektiv in Reihe zwischen den Anschlüssen der Zelle verbunden oder überbrückt sein kann, die Einrichtung umfassend:
einen Spannungsgenerator (201) zum Anlegen eines elektrischen Prüfstimulus (V_{STIM}, 301) an die erste Vielzahl von in Reihe verbundenen Zellen, wobei der elektrische Prüfstimulus eine Spannung aufweist, die niedriger als die Nennbetriebsspannung des Spannungsquellwandlers aber größer als eine Schwellenspannung (Vₜₕ) ist, die ausreicht, Freilaufdioden von jeder der ersten Vielzahl von in Reihe verbundenen Zellen in Vorwärtsrichtung vorzuspannen, um einen Leitungsweg durch die erste Vielzahl von in Reihe verbundenen Zellen bereitzustellen; und
eine Überwachungsvorrichtung (202) zum Überwachen der elektrischen Eigenschaften der ersten Vielzahl von in Reihe verbundenen Zellen mit dem elektrischen Prüfstimulus; wobei
der elektrische Stimulus (V_{STIM}) in einer Vorwärtsrichtung angelegt wird, sodass der Leitungsweg durch die Vielzahl von in Reihe verbundenen Zellen die Energiespeicherelemente umfasst; und
der elektrische Stimulus (V_{STIM}) in einer umgekehrten Richtung angelegt wird, sodass der Leitungsweg durch die Vielzahl von in Reihe verbundenen Zellen den Überbrückungsweg umfasst.

## Revendications

1. Procédé de test d'une première pluralité de cellules connectées en série (103) d'un convertisseur de source de tension (100), dans lequel chaque cellule (103) comprend un élément de stockage d'énergie (105) et une pluralité d'éléments de commutation (106), dans lequel chaque élément de commutation est associé à une diode de roue libre (107), et dans lequel les cellules comprennent des sous-modules en demi-pont dans lesquels la pluralité d'éléments de commutation sont configurés de sorte que l'élément de stockage d'énergie puisse, en utilisation, être connecté de manière sélective en série entre les bornes de la cellule ou mis en dérivation, le procédé comprenant les étapes consistant à :
appliquer un stimulus de test électrique (V_{STIM} ; 301) à la première pluralité de cellules connectées en série, dans lequel le stimulus de test électrique a une tension qui est inférieure à la tension de fonctionnement nominale du convertisseur de source de tension mais qui est supérieure à une tension de seuil (Vₜₕ) qui est suffisante pour polariser vers l'avant des diodes de roue libre de chacune de la première pluralité de cellules connectées en série afin de fournir un trajet de conduction à travers la première pluralité de cellules connectées en série ; et
surveiller les caractéristiques électriques de ladite première pluralité de cellules connectées en série audit stimulus de test électrique ; dans lequel
le stimulus électrique (V_{STIM}) est appliqué dans une direction vers l'avant de sorte que le trajet de conduction à travers la pluralité de cellules connectées en série comprend les éléments de stockage d'énergie ; et
le stimulus électrique (V_{STIM}) est appliqué dans une direction inverse de sorte que le trajet de conduction à travers la pluralité de cellules connectées en série comprend le trajet de dérivation.

2. Procédé selon la revendication 1, dans lequel le stimulus de test électrique a une tension qui est inférieure à la tension de fonctionnement nominale de chacune des cellules individuelles de ladite première pluralité de cellules connectées en série.

3. Procédé selon la revendication 1 ou la revendication 2, dans lequel le stimulus de test électrique a une tension (301) qui varie dans le temps.

4. Procédé selon la revendication 3, dans lequel le stimulus de test électrique a une tension (301) qui augmente à partir d'un niveau inférieur à la tension de seuil jusqu'à une valeur qui est supérieure à la tension de seuil.

5. Procédé selon l'une des quelconques revendications précédentes, dans lequel le stimulus de test électrique est limité en courant.

6. Procédé selon l'une des quelconques revendications précédentes, dans lequel la surveillance des caractéristiques électriques comprend une surveillance des caractéristiques de courant électrique de tout courant circulant à travers la première pluralité de cellules connectées en série.

7. Procédé selon l'une des quelconques revendications précédentes, comprenant une comparaison des caractéristiques électriques surveillées avec des caractéristiques attendues.

8. Procédé selon l'une des quelconques revendications précédentes, dans lequel l'application du stimulus de test électrique comprend une application d'un premier stimulus d'une première polarité suivie d'une application d'un second stimulus de la polarité opposée.

9. Procédé selon l'une des quelconques revendications précédentes, dans lequel, pendant au moins une partie du temps, le stimulus de test électrique a une tension dans la plage de 400 V à 600 V.

10. Procédé selon l'une des quelconques revendications précédentes, comprenant une connexion d'un équipement de test portable (200) à la première pluralité de cellules connectées en série pour fournir ledit stimulus de test et surveiller lesdites caractéristiques électriques.

11. Procédé selon l'une des quelconques revendications précédentes, dans lequel ladite première pluralité de cellules connectées en série comprennent une soupape (101) du convertisseur de source de tension.

12. Appareil (200) pour tester une pluralité de cellules connectées en série (103) d'un convertisseur de source de tension (100), dans lequel chaque cellule comprend un élément de stockage d'énergie (105) et une pluralité d'éléments de commutation (106), dans lequel chaque élément de commutation est associé à une diode de roue libre (107), et dans lequel les cellules comprennent des sous-modules en demi-pont où la pluralité d'éléments de commutation sont configurés de sorte que l'élément de stockage d'énergie peut, en utilisation, être connecté de manière sélective en série entre les bornes la cellule ou mis en dérivation, l'appareil comprenant :
un générateur de tension (201) pour appliquer un stimulus de test électrique (V_{STIM} ; 301) à la première pluralité de cellules connectées en série, dans lequel le stimulus de test électrique a une tension qui est inférieure à la tension de fonctionnement nominale du convertisseur de source de tension mais qui est supérieure à une tension de seuil (Vₜₕ) qui est suffisante pour polariser vers l'avant les diodes de roue libre de chacune de la première pluralité de cellules connectées en série afin de fournir un trajet de conduction à travers la première pluralité de cellules connectées en série ; et
un moniteur (202) pour surveiller les caractéristiques électriques de ladite première pluralité de cellules connectées en série audit stimulus de test électrique ; dans lequel
le stimulus électrique (V_{STIM}) est appliqué dans une direction vers l'avant de sorte que le trajet de conduction à travers la pluralité de cellules connectées en série comprend les éléments de stockage d'énergie ; et
le stimulus électrique (V_{STIM}) est appliqué dans une direction inverse de sorte que le trajet de conduction à travers la pluralité de cellules connectées en série comprend le trajet de dérivation.
